# EUROPÄISCHE PATENTSCHRIFT

(11) **EP 1 220 412 B1**
(45) Veröffentlichungstag und Bekanntmachung des Hinweises auf die Patenterteilung: **01.03.2006**
(21) Anmeldenummer: 01130418.5
(22) Anmeldetag: 20.12.2001
(51) Int. Cl.: H02J 13/00, H02J 3/00

(54) **Verfahren und Vorrichtung zur Steuerung und Überwachung des elektrischen Energieverbrauchs**
Method and device for controlling and monitoring consumption of electrical power
Procédé et dispositif pour la commande et le contrôle de la consommation d'énergie électrique

(30) Priorität: 22.12.2000 DE 10064165
(43) Veröffentlichungstag der Anmeldung: 03.07.2002
(73) Patentinhaber: Steinigeweg, Dieter, Dipl.-Ing., 64289 Darmstadt (DE)
(72) Erfinder: Steinigeweg, Dieter, Dipl.-Ing., 64289 Darmstadt (DE)
(74) Vertreter: Weber, Dieter

(56) Entgegenhaltungen:
- EP-A- 0 673 101
- WO-A-98/45718
- JP-A- 5 336 659
- JP-A- 8 063 132
- JP-A- 10 155 231
- US-A- 4 771 185
- US-A- 4 924 404

## Beschreibung

Die vorliegende Erfindung betrifft ein Verfahren zur Steuerung und Überwachung des Energieverbrauchs einer Gruppe individuell schaltbarer Energieverbraucher, wie z. B. in einem Haushalt, wobei der Energieverbrauch der Gruppe von Verbrauchern erfaßt, an eine zentrale Erfassungseinheit übermittelt und im Zeitverlauf dargestellt wird.

Ebenso betrifft die vorliegende Erfindung auch eine Vorrichtung zur Steuerung und Überwachung des Energieverbrauchs einer Gruppe individuell schaltbarer Energieverbraucher, wie z. B. in einem Haushalt, mit einer Erfassungseinrichtung zur Erfassung des Energieverbrauchs der Gruppe und mit einer Einrichtung zur graphischen Darstellung des Zeitverlaufs des Energieverbrauchs.

Eine entsprechende Vorrichtung und ein entsprechendes Verfahren sind aus der JP 05336659 bekannt. Die entsprechende Vorrichtung ist jedoch lediglich in der Lage, den Tagesverbrauchsablauf im Gesamtverbrauch, Maximallasten, etc. einer Gruppe von Verbrauchern darzustellen. Daraus ergibt sich weder die Erfassung einzelner Teilmengen der Gruppe von Verbrauchern noch eine graphische Darstellung des zeitlichen Verlaufs sowohl des Istwertes des Energieverbrauchs als auch des Sollwertes des Energieverbrauchs jeweils individuell für jede einzelne Teilmenge von Verbrauchem.

Aus der JP 08063132 sind ein Verfahren und eine Vorrichtung bekannt, welche eine Überwachung des Verbrauchs vornehmen und ein Wamsignal ausgeben, wenn die Verbrauchskurve einen (zeitabhängigen) Maximalwert zu überschreiten droht. Hierdurch erfolgt lediglich eine Begrenzung des Gesamtverbrauchs. Eine frühzeitige Erkenntnis, worauf der erhöhte Verbrauch zurückzuführen ist, läßt sich daraus nicht gewinnen.

Die JP 10155231 betrifft einen Relaisschutz. Hierfür wird eine Schutzkurve für die Relais berechnet und Strom und Spannung werden überwacht und so eingestellt, daß die Schutzkurve nicht überschritten wird.

Die WO98/45718 befaßt sich mit einer Verbrauchsmessung unter Gewichtung nach ökonomischen Parametern. Hierfür ist beispielsweise eine zeitliche Steuerung des Energieverbrauchs vorgesehen.

Die US 4,771,185 offenbart die Überwachung des Gesamtverbrauchs, wobei ein automatisches Abschalten gemäß einer vorgegebenen Prioritätenliste vorgesehen ist, wenn ein hoher Verbrauch vorliegt bzw. hohe Energiepreise zu zahlen sind. Auch diese Druckschrift liefert keinen Hinweis auf den individuellen Soll-/Istwertvergleich anhand graphischer Verlaufskurven für einzelne Teilmengen von Energieverbrauchem.

Grundsätzlich kann man die herkömmlichen Stromzähler eines Haushalts oder einer anderen Gruppe von Einzelverbrauchem als eine entsprechende Vorrichtung ansehen. Durch Ablesen des Energieverbrauchs auf dem Stromzähler kann man den Energieverbrauch erfassen, welcher durch alle Verbraucher verursacht wird, deren Stromzuleitungen über den Stromzähler laufen. Dementsprechend ist es auch möglich, den dabei festgestellten Stromverbrauch überwachen und gegebenenfalls durch Ein- oder Ausschalten einzelner Energieverbraucher zu steuem.

Allerdings ist dies ein sehr umständliches und aufwendiges Verfahren, so daß es in der Praxis kaum zur Anwendung kommt. Stattdessen bemühen sich die Betreiber entsprechender Energieverbraucher lediglich darum, gewisse Grundregeln einzuhalten, das heißt z.B. elektrische Geräte und sonstige Energieverbraucher nicht unnötig einzuschalten bzw. mit diesen Geräten nicht unnötig Strom zu verbrauchen. Dabei kann es jedoch vorkommen, daß mitunter der Energieverbrauch mancher Geräte bzw. Verbraucher unterschätzt oder einfach nicht bemerkt wird und derjenige von anderen wiederum überschätzt wird. Auch sind die Wirkungen bestimmter Maßnahmen, wie z.B. der Einsatz neuer, sparsamerer Geräte durch Ablesen herkömmlicher Stromzähler nur schwer nachzuvollziehen und zu erkennen und es ist auch im Vorfeld oft nur schwer abzuschätzen, an welcher Stelle der Ersatz alter Geräte durch neuere Geräte mit weniger Energieverbrauch nicht nur ökologisch, sondern auch ökonomisch sinnvoll ist.

Gegenüber dem vorstehend genannten Stand der Technik liegt der vorliegenden Erfindung die Aufgabe zugrunde, ein Verfahren und eine Vorrichtung zur Steuerung und Überwachung des Energieverbrauchs einer Gruppe individuell schaltbarer Energieverbraucher zu schaffen, welche die Überwachung und zeitnahe Steuerung des Energieverbrauchs erheblich erleichtern und nach Möglichkeit auch die Ursachen übermäßigen Energieverbrauchs leichter erkennbar machen.

Hinsichtlich des Verfahrens wird diese Aufgabe dadurch gelöst, daß der Energieverbrauch einzelner Teilmengen der Gruppe individuell erfaßt und übermittelt wird, wobei der zeitliche Verlauf des tatsächlichen Energieverbrauchs sowie ein entsprechender Sollwert-Verlauf graphisch dargestellt werden, und wobei Sollwerte und Istwerte sowie deren zeitlicher Verlauf für jede einzelne Teilmenge getrennt erfaßt werden und unabhängig von den übrigen Teilmengen darstellbar sind.

Hinsichtlich der entsprechenden Vorrichtung wird die der Erfindung zugrunde liegende Aufgabe dadurch gelöst, daß Teilmengen der Gruppe jeweils eine Erfassungseinrichtung für den Energieverbrauch der jeweiligen Teilmenge aufweisen, die jeweils in Kommunikationsverbindung mit der zentralen Erfassungseinheit stehen und daß mindestens ein Speicher zum Speichern von Sollwerten und Soltwert-Kennlinien der jeweiligen Teilmengen sowie zum Speichern der gemessenen Verbrauchswerte bzw. Verbrauchskennlinien der jeweiligen Teilmengen vorgesehen ist, wobei eine Einrichtung zur graphischen Darstellung der gespeicherten Sollwerte und Istwerte des Energieverbrauchs vorgesehen ist.

Ein wesentliches Merkmal der vorliegenden Erfindung liegt demnach in der zeitnahen graphischen Darstellung des tatsächlichen Energieverbrauchs im Vergleich zu einem Sollwert-Verlauf. Hierdurch werden der aktuelle Stromverbrauch im Verhältnis zu dem erwarteten Verbrauch ebenso wie ein etwaiges Fehlverhalten bzw. Fehlfunktionen sowie das vorhandene Einsparpotential für den Benutzer anschaulich sichtbar und damit transparent gemacht.

Für den Sollwert-Verlauf werden zweckmäßigerweise zunächst theoretische Überlegungen angestellt, wie der Energieverbrauch der Gruppe von Energieverbrauchern insgesamt aussehen sollte. Beispielsweise kann man sich für einen Haushalt überlegen, welche elektrischen Geräte in diesem Haushalt installiert sind und wie lange sie üblicherweise mindestens in Gebrauch sein müssen bzw. tatsächlich in Gebrauch sind, so daß sich hieraus ein Sollwert-Verlauf ergibt, der nach Möglichkeit einem optimierten Verbrauchsverhalten entsprechen sollte. Aufgrund der Erfassung des Energieverbrauchs einzelner Teilmengen der Gruppe der Energieverbraucher ist es nunmehr möglich, nicht nur etwaige Abweichungen des gesamten Energieverbrauchs aufgrund der Abweichungen von der Sollwert-Linie unmittelbar und anschaulich klar zu erkennen, sondern es ist darüber hinaus auch möglich, durch Aufschlüsselung des tatsächlichen Verbrauchs nach den einzelnen Verbrauchern, die aufgrund der Erfassung der individuellen Teilmengen möglich ist, den erhöhten Energieverbrauch gegebenenfalls bestimmten Teilmengen der Gruppe der Energieverbraucher zuzuordnen.

Besonders zweckmäßig ist es dabei, wenn jeder Teilmenge der Energieverbraucher auch ein entsprechender Sollwert für diese Teilmenge zugeordnet ist und dieser Sollwert mit dem Ist-Verbrauch vergleichbar ist. Damit kann ein etwaiger übermäßiger Energieverbrauch, der von dem zuvor festgelegten Sollwert abweicht, entweder unmittelbar einem bestimmten Verbraucher bzw. einer bestimmten Teilmenge von Verbrauchern oder auch mehreren Teilmengen der Verbraucher zugeordnet werden.

Es versteht sich, daß jeder Verbraucher der Gruppe von Energieverbrauchern einer der Teilmengen zugeordnet ist und daß jede Teilmenge mindestens einen Verbraucher umfaßt, jedoch können einzelne Teilmengen auch mehrere Verbraucher umfassen. Beispielsweise könnten in einem Haushalt sämtliche Leuchten bzw. Lampen des Haushalts oder z.B. einer Etage oder von einem oder mehreren Räumen zu einer Teilmenge der Verbraucher zusammengefaßt werden. Ebenso könnten auch alle Küchengeräte zu einer Teilmenge zusammengefaßt werden oder es könnten Waschmaschine und Wäschetrockner zusammengefaßt werden. Je kleiner die einzelnen Teilmengen sind, desto genauer ist jedoch der etwaige Mehrverbrauch einem ganz bestimmten Energieverbraucher zuzuordnen.

Weiterhin ist es zweckmäßig, wenn nicht nur der zeitliche Verlauf in Form von Sollwert-Linien und Istwert-Linien auf einer Anzeigeeinheit graphisch wiedergegeben wird (z.B. auf einem Bildschirm oder auch über einen Drucker auf einem Blatt Papier), sondern wenn darüber hinaus auch die über vorgebbare Zeiträume kumulierten Energieverbrauchswerte darstellbar sind, z.B. in Form eines Balkendiagramms. Man kann dann z.B. einen Zeitraum von 24 Stunden oder auch einen beliebigen anderen Zeitraum, z.B. Nachtzeit oder Tageszeit, für die einzelnen Teilmengen in der jeweiligen Summe darstellen. In Verbindung mit den Soll- und Istwert-Kennlinien kann dann auch sehr genau der Zeitraum ermittelt werden, während dessen möglicherweise ein ungewöhnlich hoher Verbrauch bei einer bestimmten Teilmenge stattgefunden hat. Auf diese Weise wird der Benutzer dieses Systems in sehr einfacher und direkter Weise angeleitet, die einzelnen Energieverbraucher rechtzeitig ein- oder auszuschalten, zumal die gewählte Art der Darstellung mittels Soll- und Ist-Kennlinien, die praktisch in Echtzeit stattfinden kann, so zeitnah erfolgt, daß der Benutzer den gemessenen Energieverbrauch auch unmittelbar zu der konkreten Benutzung bestimmter Geräte bzw. Verbraucher in Beziehung setzen kann.

Ein entsprechendes Display, z.B. ein einfacher Monitorbildschirm, könnte z.B. in einem Hausflur oder an einer sonstigen Stelle angeordnet werden, an welcher der Benutzer häufig vorbeikommt, so daß er jederzeit kurz einen Blick auf das Display werfen kann.

Durch entsprechende Steuerung wäre es weiterhin möglich, die Erfassungseinrichtung bzw. das Display so zu schalten bzw zu programmieren, daß neben einer Soll- und Istwert-Kennlinie für den Gesamtverbrauch zusätzlich auch immer die entsprechenden Soll- und Istwert-Linien für diejenige Teilmenge dargestellt werden, bei denen die aktuelle Abweichung des Istwerts vom Sollwert relativ am stärksten ist. Auf diese Weise kann der Benutzer bei Betrachtung des Displays z.B. feststellen, wenn vergessen worden ist, in einem Kellerraum das Licht auszuschalten, da die Sollwert-Kennlinie für Licht im Keller im allgemeinen relativ niedrig liegen sollte, da der Keller eines Hauses oft nur für kurze Zeit betreten wird, wohingegen die Ist-Kennlinie für Licht im Keller gegenüber dem Sollwert deutlich höher liegt, wenn das Ausschalten des Lichts schlicht vergessen worden ist.

Auch die verschiedenen Gesamtanteile der Verbraucher, z.B. Licht im Verhältnis zu anderem elektrischem Energieverbrauch, wie z.B. zum Backen, Kochen und Waschen, kann auf diese Weise anschaulich verdeutlicht werden und der Verbraucher wird anhand der tatsächlichen Verbrauchswerte und auch der relativen Werte des Verbrauchs in anschaulicher Weise auf besondere Schwachstellen und auf besondere Einsparungspotentiale aufmerksam gemacht.

Zweckmäßigerweise erfolgt die Erfassung des aktuellen Energieverbrauchs in digitaler Form.

Hinsichtlich der eingangs genannten Vorrichtung wird die der Erfindung zugrunde liegende Aufgabe dadurch gelöst, daß Teilmengen der Gruppe von Energieverbrauchern jeweils eine Erfassungseinrichtung für den Energieverbrauch aufweisen, die in Kommunikationsverbindung mit einer zentralen Erfassungseinheit steht.

Wie schon in Verbindung mit dem entsprechenden Verfahren beschrieben, übermitteln die Erfassungseinrichtungen über die bestehende Kommunikationsverbindung die individuellen Verbrauchswerte der einzelnen Teilmengen von Energieverbrauchern an eine zentrale Erfassungseinheit, so daß bei dieser zentralen Erfassungseinheit, die zweckmäßigerweise auch eine entsprechende Anzeigeeinheit, z.B. einen Bildschirm bzw. ein Display aufweist, die Ist-Kennlinien und die Soll-Kennlinien des Verbrauchs sowohl der gesamten Gruppe von Energieverbrauchem, die zu dem System gehören als auch bestimmte Teilmengen hiervon dargestellt werden können. Zweckmäßigerweise sind die Energieerfassungseinrichtungen A/D-Wandler (Analog-Digital-Wandler), deren Analogteil den durch eine Teilmenge der Verbraucher fließenden Strom erfaßt, wobei dieser analoge Wert dann in ein entsprechendes digitales Signal umgewandelt wird.

Die zentrale Erfassungseinheit sollte zweckmäßigerweise ein Mikroprozessor sein, der mit einem Monitor verbunden ist. Der Monitor kann auch ein relativ einfaches, flaches LCD-Display sein, das man sehr einfach an einer Wand montieren bzw. aufhängen kann.

Außerdem können noch Speichereinrichtungen vorgesehen sein, die ein oder mehrere Sollwert-Kennlinien speichern können. Zum Beispiel können verschiedene Sollwert-Kennlinien gespeichert werden für unterschiedliche Tage, das heißt gewöhnliche Werktage und Wochenendtage, für Sommertage und Wintertage, und insbesondere können auch bestimmte Kennlinien gespeichert werden für die einzelnen Verbraucher bzw. Teilmengen von Verbrauchern, auch hier wieder aufgeschlüsselt nach unterschiedlichen Tagesabläufen und Jahreszeiten.

Die Kennlinienauswahl kann z.B. programmgesteuert mit Hilfe einer integrierten Uhr und eines Kalenders erfolgen, so daß automatisch immer die passenden Kennlinien einem bestimmten Tag zu einer bestimmten Jahreszeit zugeordnet werden.

Darüber hinaus sollte auch eine Steuereinheit vorgesehen sein, durch welche wahlweise die unterschiedlichsten Kennlinien, das heißt die zeitlichen Verläufe der Sollwerte und auch der Istwerte dargestellt werden können. Über ein Programm mit entsprechender Menüführung kann der Benutzer seinen Energieverbrauch nach umfangreichen Kriterien auswerten. Hierzu ist es selbstverständlich zweckmäßig, wenn auch die Kennlinien der tatsächlichen Verbrauchswerte, das heißt der zeitliche Verlauf des Energieverbrauchs sowohl für alle Verbraucher zusammen als auch für die einzelnen Teilmengen gespeichert werden. Auch diese Speicherung kann vollständig automatisch und programmgesteuert erfolgen.

Alle Erfassungseinrichtungen bzw. A/D-Wandler sind zweckmäßigerweise über eine gemeinsame Busleitung mit der zentralen Erfassungseinheit verbunden. Dabei kann eventuell auch das in einem Gebäude vorhandene elektrische Leitungsnetz selbst als Busleitung verwendet werden, da sich hochfrequente Signale auf diesen Leitungen sehr leicht von dem normalen Wechselstromsignal unterscheiden und abtrennen lassen. Wahlweise kann aber auch eine drahtlose Verbindung zwischen den einzelnen Erfassungseinrichtungen und der zentralen Erfassungseinheit vorgesehen sein.

Weitere Merkmale, Vorteile und Anwendungsmöglichkeiten der vorliegenden Erfindung werden deutlich anhand der folgenden Beschreibung einer bevorzugten Ausführungsform und der dazugehörigen Figuren. Es zeigen:
- Figur 1: ein Schema eines Wohngebäudes mit den darin vorhandenen Energieverbrauchern und der erfindungsgemäßen Vorrichtung und
- Figur 2: ein Blockschaltbild der einzelnen Komponenten der erfindungsgemäßen Vorrichtung.

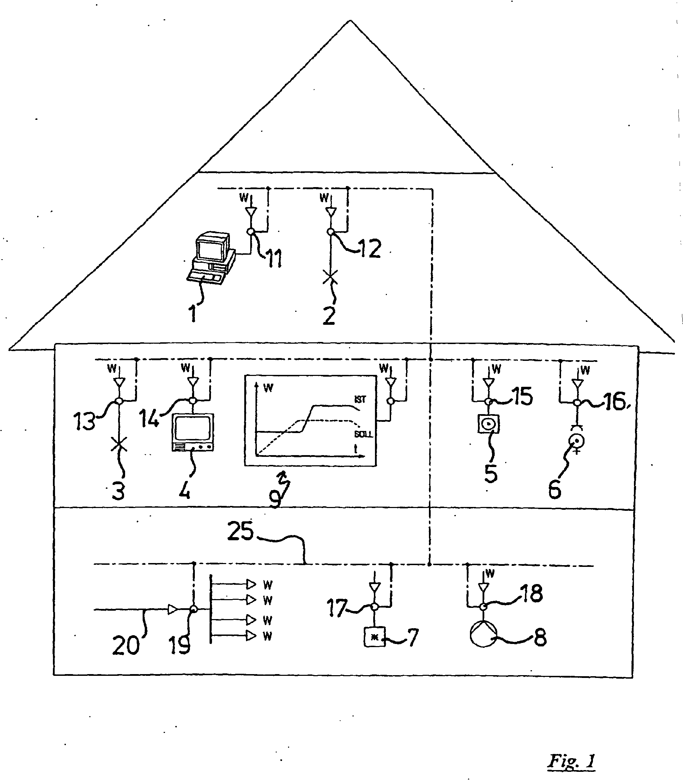

Man erkennt in Figur 1 ein schematisch im Querschnitt dargestelltes Wohngebäude. Im Untergeschoß befindet sich eine zentrale Stromversorgung 20, sowie eine zentrale Erfassungseinrichtung 19, die als Analog/Digital-Wandler ausgebildet ist und den Gesamtstromverbrauch des Gebäudes erfasst (Stromzähler). Dieser Gesamtstromverbrauch bzw. die entsprechenden durch den A/D-Wandler 19 digitalisierten Meßdaten werden über eine Busleitung 25 an eine zentrale Erfassungseinheit 9 übermittelt.

Des weiteren erkennt man in allen übrigen Geschossen verschiedene elektrische Verbrauchsgeräte, die mit 1 bis 8 durchnumeriert sind, wobei hier lediglich beispielsweise die Bezugszahl 1 einen Personal Computer bezeichnet, die Bezugszahlen 2 und 3 die Beleuchtung im Dachgeschoß bzw. im mittleren Geschoß repräsentieren, die Bezugszahl 4 Geräte der Unterhaltungselektronik kennzeichnet, 5 für eine Waschmaschine steht, 6 elektrische Warmwassererzeugung, 7 einen Kühlschrank und 8 eine elektrisch betriebene Pumpe (sei es für den Warmwasserverbrauch oder für ein Heizungssystem oder auch für eine Wärmepumpe) kennzeichnet. Die Tatsache, daß an all diesen Geräten 1 bis 8 elektrische Energie verbraucht wird, wird durch den Buchstaben "W" und einen dreieckigen Pfeil, der die Richtung des Energiestromes wiedergibt, angezeigt. Die Zuleitungen, die zu den entsprechenden Verbrauchern 1 bis 8 führen, sind jeweils mit einer Erfassungseinrichtung in Form eines A/D-Wandlers versehen, die durch die Bezugszahlen 11 bis 18 gekennzeichnet sind, wobei der jedem Verbraucher 1 bis 8 zugeordnete A/D-Wandler die entsprechende, um 10 erhöhte Bezugszahl hat.

Alle A/D-Wandler 11 bis 18 und auch der zentrale A/D-Wandier 19 sind mit der gemeinsamen Busleitung 25 verbunden. Die Busleitung kann jedoch auch durch das in dem Gebäude vorhandene, elektrische Leitungsnetz gebildet werden. Alternativ kann auch eine drahtlose Kommunikation zwischen den Erfassungseinrichtungen 11 bis 19 und der zentralen Verarbeitungseinheit 9 vorgesehen sein.

Von der zentralen Verarbeitungseinheit 9 ist in Figur 1 nur schematisch ein Display dargestellt, welches eine Soll-Kennlinie und eine Ist-Kennlinie zeigt, das heißt jeweils den angestrebten und den tatsächlichen Verlauf des elektrischen Energieverbrauchs über der Zeit.

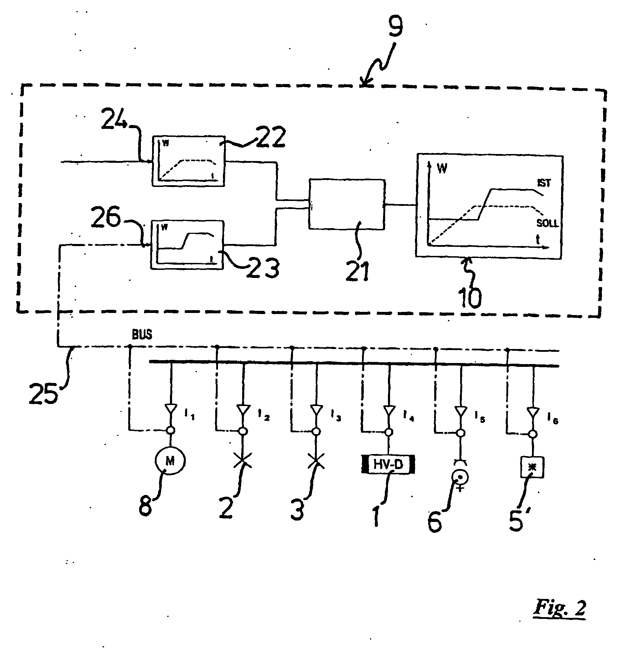

In dem Blockschaltbild gemäß Figur 2 ist die zentrale Erfassungseinheit 9 etwas detaillierter wiedergegeben. Unter der Erfassungseinheit 9 erkennt man nochmals einige beispielhaft angegebene Verbraucher, die mit der gemeinsamen Busleitung 25 verbunden sind. Dabei ist zu beachten, daß die einzelnen Verbraucher bzw. die zugehörigen A/D-Wandler grundsätzlich Teilmengen aller Verbraucher bzw. Wandler sind, die über die Stromversorgung 20 mit Energie versorgt werden bzw. diese erfassen, wobei jede Teilmenge aus mindestens einem Verbraucher besteht, andererseits aber auch mehrere Verbraucher, wie z.B. alle Beleuchtungseinrichtungen in einem Zimmer oder in einer Etage, eine Teilmenge bilden und einen gemeinsamen A/D-Wandler aufweisen können. Selbstverständlich sollte die Summe aller Teilmengen die Gesamtzahl aller über die Stromversorgung 20 versorgten Energieverbraucher umfassen, wobei eine der Verbrauch einer der Teilmengen auch als Differenz des Gesamtverbrauchs und des Verbrauchs aller übrigen Teilmengen ermittelt werden könnte.

Im oberen Teil der Figur 2 erkennt man, daß die zentrale Erfassungseinheit 9 aus einer Aufbereitungseinheit 21, z.B. in Form eines programmierbaren Mikroprozessors, besteht, der ein Display 10 nachgeschaltet ist, auf welchem der zeitliche Verlauf von Soll- und Istwerten des Stromverbrauchs darstellbar ist. Weiterhin sind der Aufbereitungseinrichtung 21 noch Kennlinienspeicher 22 für den Sollwert und 23 für den Istwert des Energieverbrauchs zugeordnet. Über den Eingang 24 können im Prinzip beliebige Sollwert-Kennlinien in den Speicher 22 einprogrammiert werden. Es versteht sich, daß auch eine entsprechende, hier nicht dargestellte Eingabe- und Programmiereinheit vorgesehen ist. Zweckmäßigerweise ist im Bereich des Displays 10 eine Eingabeeinheit in Form einer Tastatur vorgesehen und das System ist wahlweise in einen Programmierzustand oder einen Ablesezustand umschaltbar. Im Programmierzustand können z.B. über eine menügeführte Programmsteuerung bestimmte Daten eingegeben werden, die zweckmäßigerweise von dem Programm abgefragt werden, wie z.B. die insgesamt in dem Gebäude vorhandene Fläche, die Zahl der Geschosse und deren Höhe, der generelle Zustand des Gebäudes, die Zahl und Art der einzelnen Energieverbraucher, etc. Ein entsprechendes Programm berechnet aus diesen Daten Soll-Kennlinien sowohl für einzelne Teilmengen von Verbrauchern als auch für alle Verbraucher gemeinsam, wobei die Soll-Kennlinien für unterschiedliche Jahreszeiten auch einen unterschiedlichen Verlauf haben können.

Diese Soll-Kennlinien werden in dem Speicher 22 gespeichert, wobei auch über den Eingang 24 extern bestimmte oder frei gewählte Sollwert-Kennlinien eingegeben werden können. In den Speicher 23 werden dagegen über die Busleitung 25 und den Eingang 26 die von den einzelnen A/D-Wandlern 11 bis 19 erfaßten digitalen Verbrauchswerte eingegeben und gespeichert. Dabei werden die Verbrauchswerte von jedem der A/D-Wandler 11 bis 19 getrennt erfaßt und in vorgebbaren zeitlichen Abständen gespeichert. Aus der zeitlichen Abfolge der gespeicherten Energieverbrauchswerte ergeben sich Istwert-Kennlinien für jede einzelne Teilmenge der Verbraucher und auch für die Summe aller Verbraucher. Mit Hilfe der Aufbereitungseinrichtung 21 können diese Soll- und Istwert-Kennlinien auf dem Display 10 dargestellt werden.

Der Benutzer kann dann in anschaulicher Weise erkennen, wo mögliche Energieeinsparpotentiale liegen und kann sein Verbrauchsverhalten dementsprechend schnell anpassen.

Auf diese Weise können mit der erfindungsgemäßen Vorrichtung erhebliche Energieeinsparungen erzielt werden, so daß sich auch die Installation einer entsprechenden Vorrichtung relativ schnell amortisiert.

## Patentansprüche

1. Verfahren zur Steuerung und Überwachung des Energieverbrauchs einer Gruppe individuell schaltbarer Energieverbraucher, wie z. B. in einem Haushalt, wobei der Energieverbrauch der Gruppe von Verbrauchern erfaßt, an eine zentrale Erfassungseinheit (9) übermittelt und im Zeitverlauf dargestellt wird, **dadurch gekennzeichnet, daß** der Energieverbrauch einzelner Teilmengen (1-8) der Gruppe individuell erfaßt und übermittelt wird, wobei der zeitliche Verlauf des tatsächlichen Energieverbrauchs sowie ein entsprechender Sollwert-Verlauf graphisch dargestellt werden, und wobei Sollwerte und Istwerte sowie deren zeitlicher Verlauf für jede einzelne Teilmenge getrennt erfaßt werden und unabhängig von den übrigen Teilmengen darstellbar sind.

2. Verfahren nach Anspruch 1, **dadurch gekennzeichnet, daß** die Erfassungseinrichtung einen Mikroprozessor (21) aufweist.

3. Verfahren nach einem der Ansprüche 1 oder 2, **dadurch gekennzeichnet, daß** neben der Darstellung des zeitlichen Verlaufs auch der über einen vorgebbaren Zeitraum kumulierte Energieverbrauch, vorzugsweise im Verhältnis zu einem entsprechend kumulierten Sollwert, sowohl für die gesamte Gruppe als auch für die einzelnen Teilmengen der Gruppe darstellbar sind.

4. Verfahren nach einem der Ansprüche 1 bis 3, **dadurch gekennzeichnet, daß** der Energieverbrauch in digitaler Form erfaßt wird.

5. Vorrichtung zur Steuerung und Überwachung des Energieverbrauchs einer Gruppe individuell schaltbarer Energieverbraucher, wie z. B. in einem Haushalt, mit einer Erfassungseinrichtung (11-18) zur Erfassung des Energieverbrauchs der Gruppe und mit einer Einrichtung zur graphischen Darstellung des Zeitverlaufs des Energieverbrauchs, **dadurch gekennzeichnet, daß** Teilmengen (1-8) der Gruppe jeweils eine Erfassungseinrichtung (11-18) für den Energieverbrauch der jeweiligen Teilmenge aufweisen, die jeweils in Kommunikationsverbindung mit der zentralen Erfassungseinheit (9) stehen und daß mindestens ein Speicher zum Speichern von Sollwerten und Sollwert-Kennlinien der jeweiligen Teilmengen sowie zum Speichern der gemessenen Verbrauchswerte bzw. Verbrauchskennlinien der jeweiligen Teilmengen vorgesehen ist, wobei eine Einrichtung zur graphischen Darstellung der gespeicherten Sollwerte und Istwerte des Energieverbrauchs vorgesehen ist.

6. Vorrichtung nach Anspruch 5, **dadurch gekennzeichnet, daß** die Erfassungseinrichtungen A/D-Wandler sind, bei welchen der Analogteil den durch eine Teilmenge der Verbraucher fließenden Strom erfaßt und in ein dem elektrischen Energieverbrauch proportionales digitales Signal umwandelt.

7. Vorrichtung nach Anspruch 5 oder 6, **dadurch gekennzeichnet, daß** die zentrale Erfassungseinheit ein Mikroprozessor (21) ist, der mit einem Monitor (10) zur Darstellung der Soll- und istwerte des Energieverbrauchs verbunden ist.

8. Vorrichtung nach einem der Ansprüche 5 bis 7, **dadurch gekennzeichnet, daß** die Erfassungseinrichtungen (11-18) über eine gemeinsame Busleitung (25) mit der Erfassungseinrichtung (21, 23) verbunden sind.

9. Vorrichtung nach Anspruch 8, **dadurch gekennzeichnet, daß** die elektrischen Energieleitungen der Gruppe der Verbraucher die gemeinsame Busleitung bilden.

10. Vorrichtung nach Anspruch 9, **dadurch gekennzeichnet, daß** die Erfassungseinrichtungen (11-18) drahtlos mit der zentralen Erfassungseinheit (9) verbunden sind.

## Claims

1. A method of controlling and monitoring the energy consumption of a group of individually switchable energy consumers such as for example in a household, wherein the energy consumption of the group of consumers is detected, communicated to a central detection unit (9) and represented in relation to time **characterised in that** the energy consumption of individual subsets (1-8) of the group is individually detected and communicated, wherein the variation in respect of time of the actual energy consumption and a corresponding reference value variation are graphically represented, and wherein reference values and actual values and the variation in respect of time thereof are detected separately for each individual subset and can be represented independently of the other subsets.

2. A method according to claim 1 **characterised in that** the detection device has a microprocessor (21).

3. A method according to one of claims 1 and 2 **characterised in that** besides the representation of the variation in respect of time the energy consumption which is cumulated over a predeterminable period of time can be represented, preferably in relation to a correspondingly cumulated reference value, both for the entire group and also for the individual subsets of the group.

4. A method according to one of claims 1 to 3 **characterised in that** the energy consumption is detected in digital form.

5. Apparatus for controlling and monitoring the energy consumption of a group of individually switchable energy consumers such as for example in a household comprising a detection device (11-18) for detecting the energy consumption of the group and a device for the graphic representation of the variation in respect of time of the energy consumption **characterised in that** subsets (1-8) of the group have a respective detection device (11-18) for the energy consumption of the respective subset, which are respectively in communication with the central detection unit (9), and that there is provided at least one memory for the storage of reference values and reference value characteristic curves of the individual subsets and for the storage of the measured consumption values or consumption characteristic curves of the respective subsets, wherein there is provided a device for the graphic representation of the stored reference values and actual values of the energy consumption.

6. Apparatus according to claim 5 **characterised in that** the detection devices are A/D converters in which the analog portion detects the current flowing through a subset of the consumers and converts it into a digital signal proportional to the electrical energy consumption.

7. Apparatus according to claim 5 or claim 6 **characterised in that** the central detection unit is a microprocessor (21) connected to a monitor (10) for representing the reference and actual values of the energy consumption.

8. Apparatus according to one of claims 5 to 7 **characterised in that** the detection devices (11-18) are connected to the detection device (21, 23) by way of a common bus line (25).

9. Apparatus according to claim 8 **characterised in that** the electrical energy lines of the group of consumers form the common bus line.

10. Apparatus according to claim 9 **characterised in that** the detection devices (11-18) are wirelessly connected to the central detection unit (9).

## Revendications

1. Procédé de commande et de surveillance de la consommation d'énergie par un groupe de récepteurs d'énergie commutables individuellement, par exemple dans un foyer domestique, la consommation d'énergie par le groupe de récepteurs étant détectée, transmise à une unité centrale de détection (9) et représentée en fonction du temps; **caractérisé en ce que** la consommation d'énergie par des unités individuelles (1 à 8) du groupe est détectée et transmise individuellement, la variation réelle de la consommation d'énergie dans le temps ainsi qu'une variation théorique correspondante étant représentées graphiquement et des valeurs théoriques et des valeurs réelles ainsi que la variation dans le temps pour chaque unité individuelle étant détectées séparément et pouvant être représentées indépendamment des autres unités.

2. Procédé selon la revendication 1, **caractérisé en ce que** le dispositif de détection comporte un microprocesseur (21).

3. Procédé selon l'une des revendications 1 ou 2, **caractérisé en ce que** l'on peut représenter, en plus de la variation dans le temps, la consommation d'énergie cumulée sur une période prédéterminée, avantageusement en comparaison avec une valeur théorique cumulée correspondante, aussi bien pour tout le groupe que pour les unités individuelles du groupe.

4. Procédé selon l'une des revendications 1 à 3, **caractérisé en ce que** la consommation d'énergie est détectée sous forme numérique.

5. Dispositif de commande et de surveillance de la consommation d'énergie par un groupe de récepteurs d'énergie commutables individuellement, comme par exemple dans un foyer domestique, ledit dispositif comportant un dispositif de détection (11 à 18) destiné à détecter la consommation d'énergie du groupe et un dispositif de représentation graphique de la variation de la consommation d'énergie dans le temps, **caractérisé en ce que** des unités (1 à 8) du groupe comporte chacune un dispositif de détection (11 à 18) destiné à détecter la consommation d'énergie des unités respectives qui sont chacune en liaison de communication avec l'unité centrale de détection (9) et **en ce qu'**il est prévu au moins une mémoire destinée à mémoriser des valeurs théoriques et des courbes caractéristiques de valeurs théoriques des unités respectives ainsi qu'à mémoriser les valeurs de consommation mesurées respectivement des courbes de consommation des unités respectives, un dispositif de représentation graphique des valeurs théoriques mémorisées et des valeurs réelles de la consommation d'énergie étant prévu.

6. Dispositif selon la revendication 5, **caractérisé en ce que** les dispositifs de détection sont des convertisseurs A/N dans lesquels la partie analogique détecte le courant circulant dans une unité des récepteurs et le convertit en un signal numérique proportionnel à la consommation d'énergie électrique.

7. Dispositif selon la revendication 5 ou 6, **caractérisé en ce que** l'unité centrale de détection est un microprocesseur (21) qui est relié à un moniteur (10) destiné à représenter les valeurs théoriques et les valeurs réelles de la consommation d'énergie.

8. Dispositif selon l'une des revendications 5 à 7, **caractérisé en ce que** les dispositifs de détection (11 à 18) sont reliés au dispositif de détection (21, 23) par une ligne de bus commune (25).

9. Dispositif selon la revendication 8, **caractérisé en ce que** les lignes d'énergie électrique du groupe de récepteurs forment la ligne de bus commune.

10. Dispositif selon la revendication 9, **caractérisé en ce que** les dispositifs de détection (11 à 18) sont reliés sans fil à l'unité centrale de détection (9).
